# EUROPEAN PATENT SPECIFICATION

(11) **EP 0 648 859 B1**
(45) Date of publication and mention of the grant of the patent: **23.07.1997**
(21) Application number: 94306699.3
(22) Date of filing: 13.09.1994
(51) Int. Cl.: C23C 16/42

(54) **Processes for the deposition of adherent tungsten silicide films**
Verfahren zur Ablagerung von anhaftenden Wolframsilicid-Filmen
Procédé pour le dépôt de films de siliciure de tungstène adhérents

(30) Priority: 14.10.1993 US 136529
(43) Date of publication of application: 19.04.1995
(73) Proprietor: APPLIED MATERIALS, INC., Santa Clara, California 95054-3299 (US)
(72) Inventor: Chang, Mei, Cupertino, CA 95014 (US); Telford, Susan, Cupertino, CA 95014 (US); Tseng, Meng Chu, Saratoga, CA 95070 (US)
(74) Representative: Bayliss, Geoffrey Cyril

(56) References cited:
- FR-A- 2 620 736
- GB-A- 2 222 416
- GB-A- 2 261 444

## Description

This invention relates to a process for the deposition of tungsten silicide (WSiₓ) More particularly, this invention relates to an improved process for the deposition of tungsten silicide from tungsten hexafluoride and dichlorosilane.

Tungsten silicide thin films have been deposited by low pressure chemical vapor deposition (LPCVD) onto semiconductor substrates using silane (SiH₄) and tungsten hexafluoride (WF₆) as the precursor gases. The deposited coating is not as conformal over stepped topographies as is desired however, and the films have a high residual fluoride content that adversely affects device performance, as explained below.

The above process is typically applicable to depositing WSiₓ onto a semiconductor wafer having a layer of silicon oxide beneath a polysilicon layer. When the wafer is exposed to elevated temperatures, e.g., about 850°C or higher, as during annealing, the excess fluoride ions migrate through the underlying polysilicon layer and into the underlying silicon oxide layer. The silicon oxide layer thus appears to have an effective thickness increase, which in turn leads to an adverse change in electrical properties of semiconductor devices made from the layers.

When using a multichamber vacuum processing system such as that described in US Patent 4,951,601 to Maydan et al, the substrate to be coated with tungsten silicide firstly is cleaned using a fluorine scrub to remove native oxide from the polysilicon layer. The cleaned substrate is then taken into a substrate transfer chamber. This transfer chamber has a nitrogen atmosphere (subatmospheric) to prevent re-oxidation of the substrate, and contains a robot to transfer the the substrate into a processing chamber, e.g., a tungsten deposition chamber, through a slit valve having an O-ring seal. This process has become the standard process for depositing tungsten silicide from silane and WF₆. However, as substrates become larger, and feature sizes for devices become smaller, the above problems with step coverage and residual fluorine using this deposition process have become critical limiters for future applications.

A process using dichlorosilane (DCS) instead of silane has also been investigated. The resultant WSiₓ films have reduced fluorine content and are more conformal than those deposited using silane as the precursor gas, thereby providing a solution to the silane-based deposition process limitations. However, using the prior art process, the initial layers of deposition are tungsten-rich, so that the composition of the WSiₓ layer is not uniform. This first layer of tungsten-rich silicide over the substrate can delaminate during subsequent annealing. Silicon ions also tend to migrate from the polysilicon layer into the tungsten-rich silicide layer, which leads to reduced device performance. Since the delamination problem is not readily discoverable until the substrate has been fully processed, by which time a great deal of value has been added to it, the dichlorosilane method has not been widely adopted.

In an effort to overcome these problems, the process has been modified to improve the compositional uniformity of the WSiₓ layer. This can be done by depositing an initial thin layer of WSiₓ at relatively higher pressures of about 1 Torr or higher, thereby reducing the amount of tungsten in the initial layer, and then reducing the pressure to about 1 Torr or less, and continuing the deposition at that reduced pressure.

This process is described in US Patent 5 500 249 Telford et al, "Uniform Tungsten Silicide Films Produced by Chemical Vapor Deposition".

However, when WSiₓ films are deposited by the above method in a multichamber apparatus such as the Centura HT manufactured by Applied Materials, Inc, the WSiₓ films are prone to delaminate under current operating conditions.

The present invention was made while seeking a solution to an intermittent delamination problem using a multichamber apparatus. What is required is the deposition of tungsten silicide thin films that have good conformality, low fluoride content and good adhesion to a substrate such as a silicon wafer which can have one or more layers thereon.

We have found that WSiₓ films deposited from tungsten hexafluoride and dichlorosilane do not adhere to the substrate when nitrogen is present during processing. Thus in order to obtain adherent films of WSiₓ on semiconductor substrates, nitrogen must be rigorously excluded from the deposition chamber.

The following is a description of some specific embodiments of the invention with reference to the accompanying drawings, in which:
Figure 1 is a schematic cross sectional view of a tungsten deposition chamber useful herein; and
Figure 2 is a top view of a multichamber processing apparatus for processing semiconductor substrates.

Tungsten silicide thin films are made in accordance with the present invention by passing tungsten hexafluoride (WF₆), dichlorosilane (DCS) and a noble carrier gas into a tungsten deposition chamber. Nitrogen must be excluded from the reaction chamber in order to obtain films that adhere to the substrate.

The most generally used substrate is a silicon wafer having a layer of polysilicon thereon, but WSiₓ can also be deposited onto other materials such as crystalline silicon, silicon oxide, gallium arsenide and metals. Other materials and layers can be deposited over the WSiₓ thin film as well.

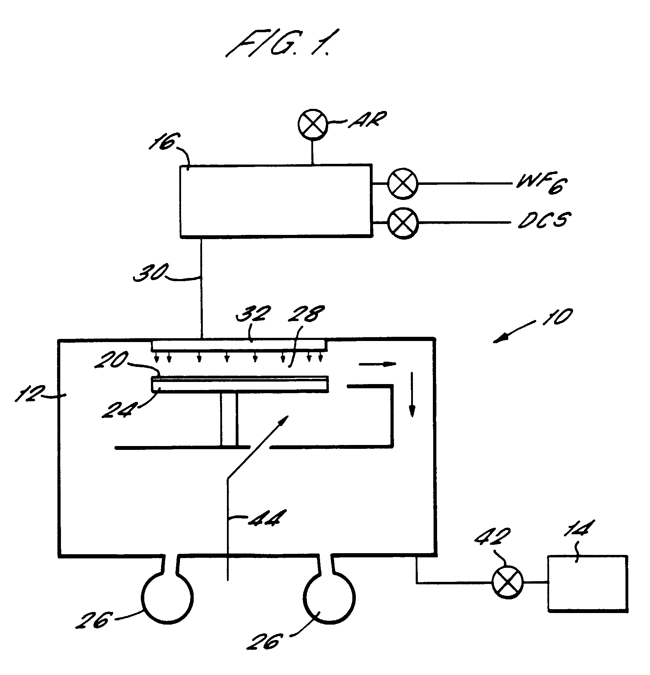

LPCVD processing chambers supplied by Applied Materials, Inc can be employed in the present deposition process. The process can be illustrated by reference to Fig. 1.

Apparatus 10 comprises a deposition chamber 12, an exhaust system 14 and gas combining assembly 16. A substrate 20, such as a silicon wafer having a layer of polysilicon thereon, is mounted on a support or susceptor 24. Heating means 26, which can be an external array of 1000 watt lamps for example, can maintain a uniform temperature during processing of the susceptor 24 and the substrate 20 mounted thereon. The deposition or reaction zone 28 lies above the substrate.

The processing gases enter the deposition chamber 12 through gas inlets 30 which lead to a "showerhead" type diffuser 32. The diffuser 32 has numerous openings over an area corresponding to that of the substrate 20 beneath it. The spacing between the diffuser 32 and the substrate 20 can be adjusted to from about 5-25.4 mm (200-1000 mils) to define the reaction zone 28. The diffuser 32 feeds the various reaction and carrier gases to the reaction zone 28. The gas combining assembly 16 mixes the various gases upstream of the diffuser 32, ensuring that the gas mixture is of uniform composition before being supplied to the diffuser 32. The exhaust system 14 is fitted with a throttle valve 42 which can regulate the pressure in the chamber. The base pressure in the chamber is about 1.3 Pa (10 millitorr). The area of the chamber below the plane of the susceptor 24 is purged through line 44 with argon to prevent reaction gases from extending into the area of the chamber 12 below the susceptor 24.

In the present process, three gases, a noble gas such as argon, DCS and WF₆ are mixed and fed to the diffuser 32.

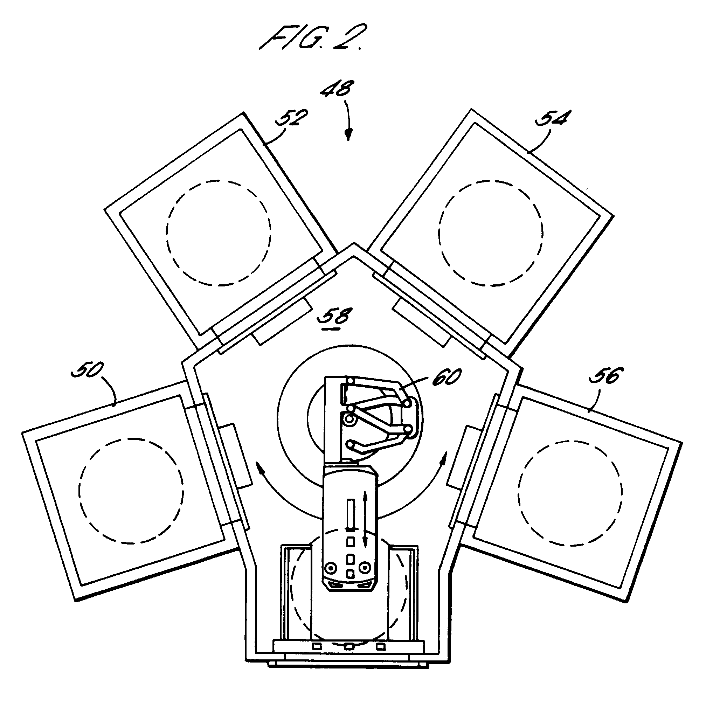

The above-described tungsten deposition chamber is advantageously employed in a multichamber apparatus such as is shown in Fig. 2.

Fig. 2 illustrates a multi-chamber unit comprising a series of processing chambers 50, 52, 54 and 56 respectively, each connected to a central transfer chamber 58. A substrate to be processed is brought into the transfer chamber 58, wherein a robot 60 transfers the substrate into one or more of the processing chambers 50-56 in a predetermined sequence. For example, a substrate can be transferred to a LPCVD chamber 50 for deposition of WSiₓ, and subsequent processing performed if desired in processing chambers 52, 54, 56, all without removing the substrate from a vacuum environment.

In accordance with the present invention however, the central transfer chamber 58 must also have a noble gas atmosphere. The pressure in the transfer chamber 58 is generally higher than that of a LPCVD chamber 50 for example, and thus if nitrogen is present in the transfer chamber 58, which is the current state of the art, the nitrogen can leak into the processing chamber 50 during transfer of the substrate. If the atmosphere in the transfer chamber 58 contains nitrogen, the substrate will also adsorb nitrogen onto its surface. The adsorbed nitrogen also will interfere with the WSiₓ deposition and the deposited films will not adhere to the substrate. Adsorbed nitrogen can be removed from the surface of the substrate by pumping under vacuum in the deposition chamber for some period of time prior to admitting processing gases; however, this step adds to the time required to process a substrate by up to about 10%, which significantly reduces the throughput of the process.

The noble gas preferred herein for reasons of economy is argon, but other noble gases can also be used. Nitrogen, generally thought of as an inert gas, cannot be used in accordance with the present process.

The tungsten silicide deposition is generally carried out at from about 500-575°C, preferably at about 550°C. The pressure during deposition can be from about 67-1333 Pa (0.5-10 torr), but preferably is carried out at about 133-400 Pa (1-3 torr).

In a typical process, WF₆ is passed into a reactor as in Fig. 1 at a rate of about 1-6 sccm, preferably at about 3.5 sccm. Dichlorosilane is passed into the reastor at a flow rate of about 130-300 sccm, preferably at about 150 sccm. Argon is used as the carrier gas and is passed into the reactor at a flow rate of about 100-1000 sccm, preferably at 300-600 sccm. The various flow rates are adjusted so as to obtain a WSiₓ layer having a resistivity of between 700 and 1400 micro-ohm-cm, preferably about 800 micro-ohm-cm. Deposition is most preferably carried out at 550°C and 133 Pa (1 torr).

If the above process is carried out in the presence of nitrogen from any source, we have found that the WSiₓ film delaminates from the substrate. Nitrogen can be admitted into the processing chamber in several ways; through the process gas lines; by means of a vacuum leak to atmosphere; by means of a leak in the O-ring seal of the wafer slit valve when it is connected to a nitrogen atmosphere substrate handling area; or by adsorbed nitrogen on the surface of a substrate exposed to nitrogen that is not removed prior to processing. If nitrogen is excluded from the deposition chamber, a strongly adherent WSiₓ film is obtained; e.g., it passes the scotch tape test.

When the above process is carried out in an apparatus of Fig. 2 using an argon carrier gas but the transfer chamber is filled with nitrogen, delamination can occur spontaneously. Thus the transfer chamber must be filled with a noble gas atmosphere as well. Further, all gases supplied to the processing chamber must be free of nitrogen. In the event the substrate has been exposed to a nitrogen atmosphere, a purge of 45 seconds or longer in argon can be used to eliminate adsorbed nitrogen from the substrate surface, but at the expense of throughput.

The invention will be further explained with reference to the following examples, but the invention is not meant to be limited to the details disclosed therein.

### Example

WSiₓ was deposited onto a silicon wafer having a layer of polysilicon thereon in an Applied Materials System 5000 CVD chamber as follows: 475 sccm of argon, 175 sccm of dichlorosilane and 4 sccm of tungsten hexafluoride were premixed and passed into the chamber. The chamber temperature was maintained at 550°C and the chamber pressure maintained at 133 Pa (1 torr) during the deposition.

A strongly adherent WSiₓ film on the polysilicon layer was obtained.

### Control 1

The process of Example 1 was followed except that a 0.2 Pa/min (1.5 millitorr/min) leak of nitrogen across the slit valve O-ring seal to the transfer chamber was discovered. The WSiₓ spontaneously delaminated before the wafer was removed from the processing chamber.

### Control 2

The procedure of Control 1 was followed except that a leak of nitrogen was present as in Example 2. After closing the slit valve, the chamber was pumped for various periods of time to determine how long it took to remove nitrogen from the wafer and to prevent delamination. After pumping for 45 seconds prior to depositing the WSiₓ film, delamination was prevented.

### Control 3

The procedure of Example 1 was followed except using the following gas flows: argon 475 sccm; nitrogen 200 sccm; dichlorosilane 175 sccm; and tungsten hexafluoride 4 sccm. The resultant film peeled away from the substrate spontaneously.

### Control 4

The reaction conditions of Control 1 was repeated except using silane as the reaction gas. No delamination occurred. Thus the present dichlorosilane-based process is more sensitive to the presence of nitrogen than a silane-based process.

### Control 5

The reaction of Example 1 was followed except that nitrogen was pumped away while maintaining a pressure in the chamber about the same as the pressure in the transfer chamber, i.e., about 666.5 Pa (5 torr). Unless nitrogen was pumped away in the deposition chamber for at least about 45 seconds, the WSiₓ films delaminated.

Although the invention has been described with respect to particular reaction conditions and flow rates, the invention is not means to be so limited. The process of the invention is only meant to be limited by the appended claims.

## Claims

1. A process for depositing WSiₓ onto the surface of a semiconductor substrate in a low pressure chemical vapor deposition chamber which comprises
a) removing all nitrogen from the surface of the substrate;
b) passing a mixture of a noble gas, dichlorosilane and tungsten hexafluoride into the reaction chamber at a pressure of from 66.7 to 1333 Pa (0.5 to 10 torr) and a temperature of from about 500-575°C, whereby an adherent WSiₓ film on the substrate is obtained.

2. A process according to claim 1 wherein said noble gas is argon.

3. A process according to claim 1 wherein nitrogen is removed from the surface of said substrate by purging with argon.

4. A process according to claim 1 wherein flow rates of 100-1000 sccm for argon, 130-300 sccm of dichlorosilane and 1-6 sccm for tungsten hexafluoride are used.

5. A process according to claim 1 wherein the temperature is 550°C.

6. A process according to claim 1 wherein the pressure is 133-400 Pa (1-3 torr).

7. A process-according to claim 1 wherein the substrate is a silicon wafer.

8. A process according to claim 1 wherein the substrate is a silicon wafer having a layer of polysilicon thereon.

9. A process according to claim 1 wherein the substrate is a silicon wafer having a layer of silicon oxide thereon.

10. A process according to claim 1 wherein said chamber is attached to a transfer chamber and the transfer chamber has an argon atmosphere.

11. In a process for depositing WSiₓ onto the surface of a silicon wafer in a multichamber vacuum system comprising a transfer chamber connected to a single wafer low pressure chemical vapor deposition chamber, the improvement comprising
a) maintaining a noble gas atmosphere in said transfer chamber;
b) passing a mixture of a noble gas carrier, dichlorosilane and tungsten hexafluoride into said deposition chamber at a pressure of from 66.7 to 1333 Pa (0.5-10 torr) and a temperature of from 500-575°C, whereby an adherent WSiₓ layer is deposited onto the wafer.

12. A process according to claim 11 wherein said noble gas is argon.

13. A process according to claim 11 wherein said wafer has a layer of polysilicon thereon.

14. A process for depositing WSiₓ onto the surface of a semiconductor substrate in a low pressure chemical vapor deposition chamber which comprises
a) removing all nitrogen from the surface of the substrate;
b) passing a mixture of a noble gas, dichlorosilane and tungsten hexafluoride into the reaction chamber so that an adherent WSiₓ film on the substrate is obtained.

15. A process according to claim 14 wherein said reaction chamber is maintained at a pressure of from 66.7 to 1333 Pa (0.5 to 10 torr).

16. A process according to claim 14 wherein said reaction chamber is maintained at a temperature of from 500-575°C.

17. A process according to claim 14 wherein an initial thin layer of WSiₓ is deposited at pressures of 133 Pa (1 Torr) or higher, the pressure is reduced to 133 Pa (1 torr) or less, and the deposition continued at the reduced pressure.

## Patentansprüche

1. Verfahren zur Abscheidung von WSiₓ auf die Oberfläche eines Halbleitersubstrats in einer Niederdruckkammer für chemische Dampfabscheidung, bei dem
a) der gesamte Stickstoff von der Oberfläche des Substrats entfernt wird;
b) eine Mischung aus einem Edelgas, Dichlorsilan und Wolframhexafluorid in die Reaktionskammer bei einem Druck von 66,7 bis 1333 Pa (0,5 bis 10 Torr) und einer Temperatur von ungefähr 500-575°C eingeführt wird wodurch ein haftender WSiₓ-Film auf dem Substrat erhalten wird.

2. Verfahren nach Anspruch 1, bei dem das Edelgas Argon ist.

3. Verfahren nach Anspruch 1, bei dem Stickstoff von der Oberfläche des Substrates durch Spülung mit Argon entfernt wird.

4. Verfahren nach Anspruch 1, bei dem Durchsätze von 100-1000 sccm Argon, 130-300 sccm Dichlorsilan und 1-6 sccm Wolfranhexafluorid verwendet werden.

5. Verfahren nach Anspruch 1, bei dem die Temperatur 550°C beträgt.

6. Verfahren nach Anspruch 1, bei dem der Druck 133-400 Pa (1-3 Torr) beträgt.

7. Verfahren nach Anspruch 1, bei dem das Substrat ein Siliciumwafer ist.

8. Verfahren nach Anspruch 1, bei dem das Substrat ein Siliciumwafer ist, auf dem sich eine Schicht aus Polysilicium befindet.

9. Verfahren nach Anspruch 1, bei dem das Substrat ein Siliciumwafer ist, auf dem sich eine Schicht aus Siliciumoxid befindet.

10. Verfahren nach Anspruch 1, bei dem die Kammer an einer Transferkammer angebracht ist und die Transferkammer eine Argonatmosphäre aufweist.

11. Verfahren zur Abscheidung von WSiₓ auf der Oberfläche eines Siliciumwafers in einem Mehrkammervakuumsystem, das eine Transferkammer aufweist, die mit einer Niederdruckkammer für chemische Dampfabscheidung für einen einzelnen Wafer verbunden ist, wobei die Verbesserung darin besteht, daß
a) eine Edelgasatmosphäre in der Transferkammer aufrechterhalten wird;
b) eine Mischung aus einem Edelgasträger, Dichlorsilan und Wolframhexafluorid in die Abscheidungskammer bei einem Druck von 66,7-1333 Pa (0,5-10 Torr) und einer Temperatur von 500-575°C geführt wird, wodurch eine haftende WSiₓ-Schicht auf dem Wafer abgeschieden wird.

12. Verfahren nach Anspruch 11, bei dem das Edelgas Argon ist.

13. Verfahren nach Anspruch 11, bei dem sich auf dem Wafer eine Schicht aus Polysilicium befindet.

14. Verfahren zur Abscheidung von WSiₓ auf der Oberfläche eines Halbleitersubstrats in einer Niederdruckvakuumkammer für chemische Dampfabscheidung, bei dem
a) der gesamte Stickstoff von der Oberfläche des Substrats entfernt wird;
b) eine Mischung aus einem Edelgas, Dichlorsilan und Woframhexafluorid in die Reaktionskammer geführt wird, so daß ein haftender WSiₓ-Film auf dem Substrat erhalten wird.

15. Verfahren nach Anspruch 14, bei dem die Reaktionskammer bei einem Druck von 66,7-1333 Pa (0,5-10 Torr) gehalten wird.

16. Verfahren nach Anspruch 14, bei dem die Reaktionskammer bei einer Temperatur von 500-575°C gehalten wird.

17. Verfahren nach Anspruch 14, bei dem eine anfängliche dünne Schicht aus WSiₓ bei einem Druck von 133 Pa (1 Torr) oder höher aufgebracht wird, der Druck auf 133 Pa (1 Torr) oder weniger verringert wird, und die Abscheidung bei dem verringerten Druck fortgeführt wird.

## Revendications

1. Procédé pour déposer WSI_{X} sur la surface d'un substrat semi-conducteur dans une chambre de dépôt de vapeur chimique à basse pression, ce procédé comprenant:
a) l'enlèvement de la totalité de l'azote de la surface du substrat;
b) le passage d'un mélange d'un gaz noble, de dichlorosilane et d'hexafluorure de tungstène dans la chambre de réaction, à une pression de 66,7 Pa à 1333 Pa (0,5 à 10 torrs) et à une température d'environ 500 à 575°C, ce qui permet d'obtenir un film adhérent de WSI_{X} sur le substrat.

2. Procédé selon la revendication 1, dans lequel ledit gaz noble ou gaz rare est de l'argon.

3. Procédé selon la revendication 1, dans lequel l'azote est enlevé de la surface dudit substrat par purge à l'argon.

4. Procédé selon la revendication 1, dans lequel on utilise des débits de 100 à 1000 cm³ normaux pour de l'argon, de 130 à 300 cm³ normaux de dichlorosilane et de 1 à 6 cm³ normaux pour l'hexafluorure de tungstène.

5. Procédé selon la revendication 1, dans lequel la température est de 550°C.

6. Procédé selon la revendication 1, dans lequel la pression est de 133 à 400 Pa (1 à 3 torrs).

7. Procédé selon la revendication 1, dans lequel le substrat est une pastille ou "puce" de silicium.

8. Procédé selon la revendication 1, dans lequel le substrat est une pastille ou puce de silicium comportant à sa surface une couche de silicium polycristallin ("polysilicium").

9. Procédé selon la revendication 1, dans lequel le substrat est une pastille ou puce de silicium comportant à sa surface une couche d'oxyde de silicium.

10. Procédé selon la revendication 1, dans lequel ladite chambre est reliée et fixée à une chambre de transfert, et la chambre de transfert comporte une atmosphère d'argon.

11. Dans un procédé pour déposer WSI_{X} sur la surface d'une pastille ou puce de silicium dans un système à chambres multiples sous vide comprenant une chambre de transfert reliée à une chambre unique de dépôt de vapeur chimique à basse pression sur une pastille, le perfectionnement comprenant:
a) le maintien d'une atmosphère de gaz rare ou noble dans ladite chambre de transfert;
b) le passage d'un mélange d'un gaz noble comme véhicule porteur, de dichlorosilane et d'hexafluorure de tungstène dans ladite chambre de dépôt à une pression de 66,7 Pa à 1333 Pa (0,5 à 10 torrs) et à une température de 500 à 575°C, de sorte qu'une couche adhérente de WSiₓ est déposée sur la pastille ou la "puce".

12. Procédé selon la revendication 11, dans lequel ledit gaz noble est de l'argon.

13. Procédé selon la revendication 11, dans lequel ladite pastille ou puce comporte à sa surface une couche de silicium polycristallin ("polysilicium").

14. Procédé pour déposer du WSiₓ sur la surface d'un substrat semi-conducteur dans une chambre de dépôt de vapeur chimique à basse pression, qui comprend:
a) l'enlèvement de la totalité de l'azote de la surface du substrat;
b) le passage d'un mélange d'un gaz noble ou rare, de dichlorosilane et d'hexafluorure de tungstène dans la chambre de réaction, de sorte que l'on obtient un film adhérent de WSiₓ sur le substrat.

15. Procédé selon la revendication 14, dans lequel ladite chambre de réaction est maintenue à une pression de 66,7 Pa à 1333 Pa (0,5 à 10 torrs).

16. Procédé selon la revendication 14, dans lequel ladite chambre de réaction est maintenue à une température de 500 à 575°C

17. Procédé selon la revendication 14, dans lequel une mince couche initiale de WSiₓ est déposée à des pressions égales ou supérieures à 133 Pa (1 torr), la pression est réduite à une valeur égale ou inférieure à 133 Pa (1 torr) et le dépôt est poursuivi à la pression réduite.
